(19) **Europäisches Patentamt / European Patent Office / Office européen des brevets**

(11) **EP 2 541 775 B1**

(12) **EUROPEAN PATENT SPECIFICATION**

(45) Date of publication and mention
of the grant of the patent:
**13.08.2014   Bulletin 2014/33**

(51) Int Cl.:
*H03M 1/14* *(2006.01)*     *H03M 1/36* *(2006.01)*
*H03M 1/74* *(2006.01)*

(21) Application number: **12173315.8**

(22) Date of filing: **22.06.2012**

(54) **Analog pre-processing circuit for analog-to-digital converters of the folding type**

Schaltkreis zur Vorverarbeitung für Faltungs-Analog-Digital-Wandler

Circuit de prétraitement analogique pour convertisseurs analogiques-numériques de type analogique à repliement

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **23.06.2011  IT RM20110331**

(43) Date of publication of application:
**02.01.2013   Bulletin 2013/01**

(73) Proprietor: **Università Degli Studi Roma Tre
Roma (IT)**

(72) Inventor: **Leccese, Fabio
00041 Albano Laziale (IT)**

(74) Representative: **Bergadano, Mirko et al
Studio Torta S.p.A.
Via Viotti, 9
10121 Torino (IT)**

(56) References cited:
**WO-A1-90/03066**

**Description**

## TECHNICAL SECTOR OF THE INVENTION

The present invention relates, in general, to analog-to-digital conversion and, in particular, to an analog pre-processing circuit for analog-to-digital converters of a folding type.

## STATE OF THE ART

As is known, an analog-to-digital converter (ADC) is an electronic circuit capable of converting an analog signal, for example a voltage, into a digital output. Currently, there exist various types of ADCs, such as for example:

- direct-conversion ADCs, or flash ADCs, which are the fastest converters and are used for sampling high-frequency signals;
- successive-approximation ADCs;
- tracking ADCs; and
- so-called "pipeline ADCs", also known as "subranging ADCs".

In particular, subranging ADCs carry out conversion in two successive steps and use a lower number of comparators and of resistances as compared to flash ADCs. Subranging ADCs are slower than flash ADCs, but, in the families of ADCs, they are the ones that most closely approximate the speed thereof reducing, however, the typical defects thereof, such as low resolution.

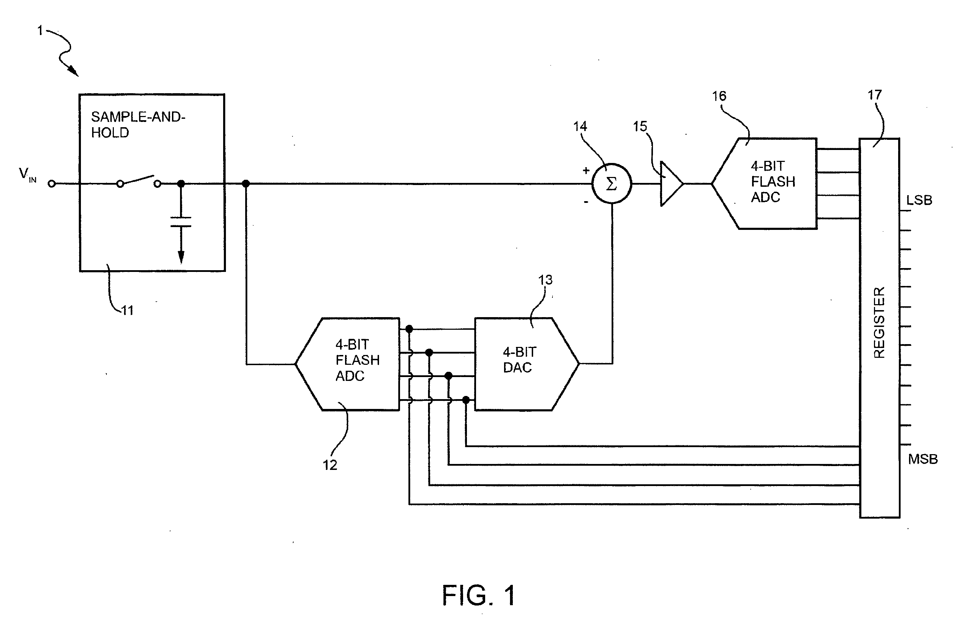

By way of example, Figure 1 shows a block diagram that represents a classic 8-bit subranging ADC, designated as a whole by 1.

In particular, as shown in Figure 1, the subranging ADC 1 comprises:

- a sample-and-hold 11,

  - which receives at input an analog signal $V_{IN}$ in the form of voltage the analog values of which are to be converted into corresponding 8-bit digital words; and
  - which samples said input voltage $V_{IN}$;

- a first 4-bit flash ADC 12, which is coupled to the sample-and-hold 11 for receiving the sampled input signal and converts each sample into a corresponding first 4-bit digital word; this first analog-to-digital (A/D) conversion, and hence the first flash ADC 12, is referred to as coarse quantization/quantizer;
- a 4-bit digital-to-analog converter (DAC) 13, which is coupled to the first ADC 12 for receiving the first 4-bit digital words and converts them into a first analog signal;
- an adder node 14, which is coupled to the sample-and-hold 11 for receiving the sampled input signal and to the DAC 13 for receiving the first analog signal and supplies at output a second analog signal obtained as difference between the sampled input signal and the first analog signal;
- an amplifier 15, which is coupled to the adder node 14 for receiving the second analog signal and amplifies said second analog signal;
- a second 4-bit flash ADC 16, which is coupled to the amplifier 15 for receiving the amplified second analog signal and converts each value of the amplified second analog signal into a corresponding second 4-bit digital word; this second A/D conversion, and hence the second flash ADC 16, is referred to as fine quantization/quantizer; and
- an 8-bit register 17, which is coupled to the first flash ADC 12 for receiving at input the first 4-bit digital words and to the second flash ADC 16 for receiving at input the second 4-bit digital words and stores 8-bit digital words that correspond to the values of the input voltage $V_{IN}$ and that comprise, as most significant bits (MSBs), the 4 bits of the first digital words and, as least significant bits (LSBs), the 4 bits of the second digital words.

As has been just described, the 8-bit subranging ADC 1 uses two 4-bit stages for digitizing the analog input signal $V_{IN}$. The first flash ADC 12 generates the 4 most significant bits (MSBs), whereas the second flash ADC 16 generates the 4 least significant bits (LSBs). The subranging ADC 1 uses 32 operational amplifiers (15 comparators for each flash ADC plus one for the DAC and one for the adder node), as against the 255 comparators required for an 8-bit flash converter. The division into a number of stages, in the A/D conversion, is not necessarily the one just described and shown in Figure 1; in fact, a 12-bit subranging ADC can, for example, use two 6-bit stages, three 4-bit stages, or four 3-bit stages.

In particular, the first flash ADC 12 carries out coarse quantization on $2^4$=16 quantization levels of the sampled input signal, discriminating the different quantization levels via $2^4-1 = 15$ voltages that are multiple of a predefined quantization voltage Vq. Consequently, if the analog input signal $V_{IN}$ assumes a value comprised between the generic voltages nVq and $(n+1)V_q$, with n comprised between 1 and 15, the first flash ADC 12, committing the inevitable quantization error, returns a first digital word corresponding to the n-th quantization level. When this first digital word is converted again by the DAC 13, the corresponding value nVq of the first analog signal is obviously different from the original one at input. Since the adder node 14 carries out the subtraction between the original value and the one reconstructed by the DAC 13, the result is always a voltage level lower than, or equal to, the value of the quantization voltage Vq. It may hence be said that the second flash ADC 16 converts the quantization error of the first flash ADC 12.

In the final stages, subranging ADCs generally use extra bits in order to correct the errors committed in the previous stages. For example, a 12-bit pipeline ADC could comprise three stages: a 4-bit one, and two subsequent 5-bit ones; the output register stores the result of the first conversion, and via an appropriate logic the bits from each stage are combined at output.

The classic structure of a subranging ADC shows how the conversion time is linked to the first flash ADC, to the digital/analog conversion, to the subtraction of the adder node, and to the last flash ADC.

The structure of the flash ADC suggests that the delay time to obtain the output is given by the propagation time of the operational amplifiers that make it up. It is evident that the propagation time of only one of them is to be considered, given that the operational amplifiers are in parallel.

The time taken by the signal to traverse the DAC is due to two factors. The first factor is linked to the time employed for closing or opening the electronic switches inside it, which are also in parallel, whilst the second factor is linked to the propagation time of the operational amplifier of the final stage of the DAC.

It may be stated that the total conversion time is the sum of the propagation times of each individual stage. It is consequently intuitive that, reducing the number of stages, the conversion time decreases.

Asubraging ADC according to the preamble of claim 1 is shown in WO90/03066.

In the family of subranging ADCs, in addition to the classic architecture, a second structure is present referred to as "folding" architecture, which eliminates the DAC and the adder node replacing them with another structure capable of merging their functionalities, with a saving in terms of conversion time. The purpose of the folding configuration is to form the residual signal indicating the quantization error committed in the coarse A/D conversion via the use of a simple analog circuit referred to as "analog pre-processor", thus ruling out the need for the DAC and the subtractor. In this embodiment, the low-dynamic residual signal generated by the analog pre-processor drives the fine quantizer directly.

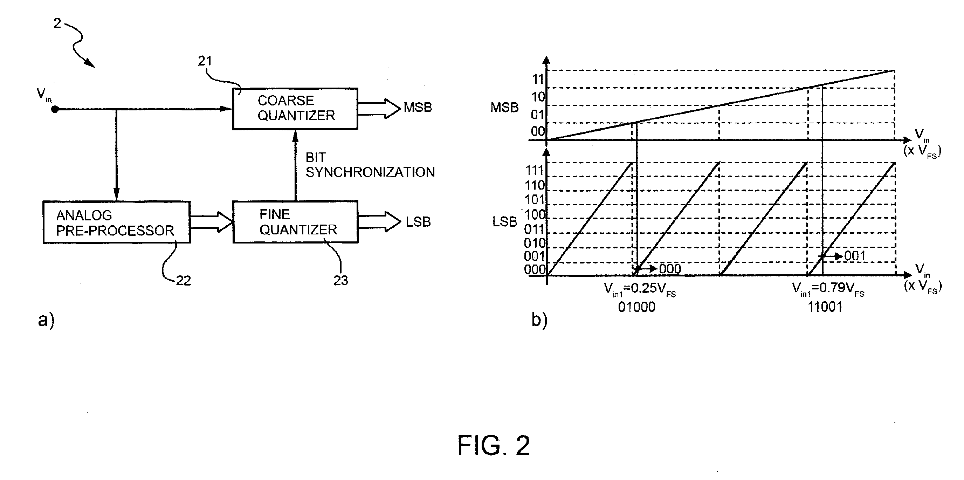

In this regard, Figure 2 shows a block diagram of a 5-bit folding ADC (Figure 2a) together with the respective transfer characteristic (Figure 2b).

In particular, the folding ADC shown in Figure 2a is designated as a whole by 2 and comprises:

- a coarse quantizer 21, which receives at input an analog signal $V_{IN}$ in the form of voltage, the analog values of which are to be converted into corresponding 5-bit digital words, and supplies at output the 2 most significant bits (MSBs) of said 5-bit digital words;
- an analog pre-processing circuit, or analog pre-processor, 22, which receives at input the analog signal $V_{IN}$ and supplies at output a corresponding pre-processed analog signal; and
- a fine quantizer 23, which is coupled to the analog pre-processor 21 for receiving at input the pre-processed analog signal and supplies at output the 3 least significant bits (LSBs) of the 5-bit digital words.

As shown in Figure 2a, the coarse quantizer 21 and the fine quantizer 23 are synchronized with one another.

Moreover, Figure 2b shows:

- a first graph (graph at the top in Figure 2b) that represents the transfer characteristic of the coarse quantizer 21, i.e., the relation between the analog input signal $V_{IN}$ and the 2 MSBs supplied at output by said coarse quantizer 21; and
- a second graph (graph shown at the bottom in Figure 2b) that represents the transfer characteristic of the fine quantizer 23, i.e., the relation between the pre-processed analog signal supplied at output by the analog pre-processor 22 and the 3 LSBs supplied at output by said fine quantizer 23.

As has been just described, the resolution of the folding ADC 2 is given by $N_{TOT} = N_{MSB}+M_{LSB}$, where $N_{MSB}$ and $M_{LSB}$ are the resolution bits in the two steps of coarse and fine quantization. In particular, we have $N_{MSB}=2$, $M_{LSB}=3$ and, hence, $N_{TOT}=5$. Assuming that the input signal $V_{IN}$ is a linear ramp that rises from 0 V to the end-of-scale value $V_{FS}$ of the input dynamics of the folding ADC 2 as a whole, the output of the analog pre-processor 22 (graph shown at the bottom in Figure 2b) is a saw-toothed signal with 4 teeth. In this way, a comparator present in the folding ADC 2 identifies 4 zero-crossing points, whereas a comparator in a classic flash ADC would identify just one. This entails that in the 5-bit folding ADC 2 a total of 10 comparators is required (3 for the coarse conversion and 7 for the fine conversion), whereas a 5-bit flash ADC requires 31 comparators. For the example just described and shown in Figure 2, it may be said that the total number of comparators of a flash ADC is reduced, in a folding architecture, by a folding factor $F_F$ equal to 4.

In the folding architecture, the analog pre-processing circuit 22 represents the most important part of the circuit because both the coarse quantizer 21 and the fine quantizer 23 are simple flash ADCs.

There currently exist various methods for implementing an analog pre-processing circuit for a folding ADC. The most elementary configuration is based upon the use of diodes and is very simple to implement, but is inadequate in the case of input signals with wide dynamics.

Another configuration is based upon the current mirror and is very suitable for obtaining saw-toothed signals with high characteristics of linearity. This version is very much appreciated for low-power and low-voltage input signals, but, in order to obtain adequate levels of accuracy, it is required that the length of the transistors that make up the analog pre-processing circuit be considerable, with consequent reduction in speed of the device and hence in the bandwidth.

Another technique uses folding amplifiers based upon transfer functions with hyperbolic tangents of differential voltage pairs. This scheme solves the problems of bandwidth, but suffers from an intrinsic distortion of output current, which limits the resolution thereof. In part these problems are solved by a so-called "wired-OR" structure mounted in the differential output pairs, which reduces the common-mode signal and provides a buffering thereof, but this suffers once again from effects of threshold perturbation linked to a scheme of a "single-ended" type.

Other circuits present in the literature are based upon schemes difficult to implement because they envisage the use of metal-oxide-semiconductor field-effect transistors (MOSFETs) with substrate detached from the source electrode, referred to hereinafter, for simplicity of description, source, which are difficult to find on the market. At the same time, they present major difficulties of manufacture using integrated technology owing to the simultaneous presence of MOSFETs with substrate shortcircuited to the source, which entails the need to provide silicon islands to separate each individual transistor from the rest of the circuit.

## OBJECT AND SUMMARY OF THE INVENTION

The aim of the present invention is hence to provide an analog pre-processing circuit for analog-to-digital converters of a folding type that will be able to alleviate the disadvantages previously described.

In particular, the present invention proposes providing an improved analog pre-processing circuit, which exploits devices that are readily available on the market and can be easily manufactured using the integrated technology.

The aforesaid aim is achieved by the present invention in so far as it relates to an analog pre-processing circuit for an analog-to-digital converter of a folding type and to an analog-to-digital converter of a folding type, according to what is defined in the annexed claims.

## BRIEF DESCRIPTION OF THE DRAWINGS

For a better understanding of the present invention, some preferred embodiments, provided purely by way of explanatory and non-limiting example, will now be illustrated with reference to the annexed drawings (not in scale), wherein:

- Figure 1 is a schematic illustration of a classic 8-bit analog-to-digital converter of a subranging type;
- Figure 2 is a schematic illustration of a 5-bit analog-to-digital converter of a folding type together with the respective transfer characteristic;
- Figure 3 is a schematic illustration of an analog pre-processor for analog-to-digital converters of a folding type according to a first preferred embodiment of the present invention;
- Figure 4 is a schematic illustration of an analog pre-processor for analog-to-digital converters of a folding type according to a second preferred embodiment of the present invention;
- Figures 5-9 and 11-12 are schematic illustrations of different portions of the analog pre-processor of Figure 4;
- Figure 10 shows a transfer characteristic of a specific portion of the analog pre-processor of Figure 4;
- Figure 13 shows the transfer characteristic of the entire analog pre-processor of Figure 4; and
- Figure 14 is a schematic illustration of an alternative embodiment of a component of the analog pre-processor according to the present invention.

## DETAILED DESCRIPTION OF PREFERRED EMBODIMENTS OF THE INVENTION

The ensuing description is provided for enabling a person skilled in the sector to implement and use the invention. Various modifications to the embodiments presented will be immediately evident to persons skilled in the sector, and the generic principles disclosed herein could be applied to other embodiments and applications, without thereby departing from the scope of protection of the present invention.

Hence, the present invention is not to be understood as being limited to just the embodiments described and shown, but it must be granted the widest scope of protection consistently with the principles and characteristics presented herein and defined in the annexed claims.

The present invention relates to an analog pre-processing circuit, in what follows also referred to as "analog pre-processor", for analog-to-digital converters of a folding type (in what follows called, for simplicity of description, ADCs or A/D converters).

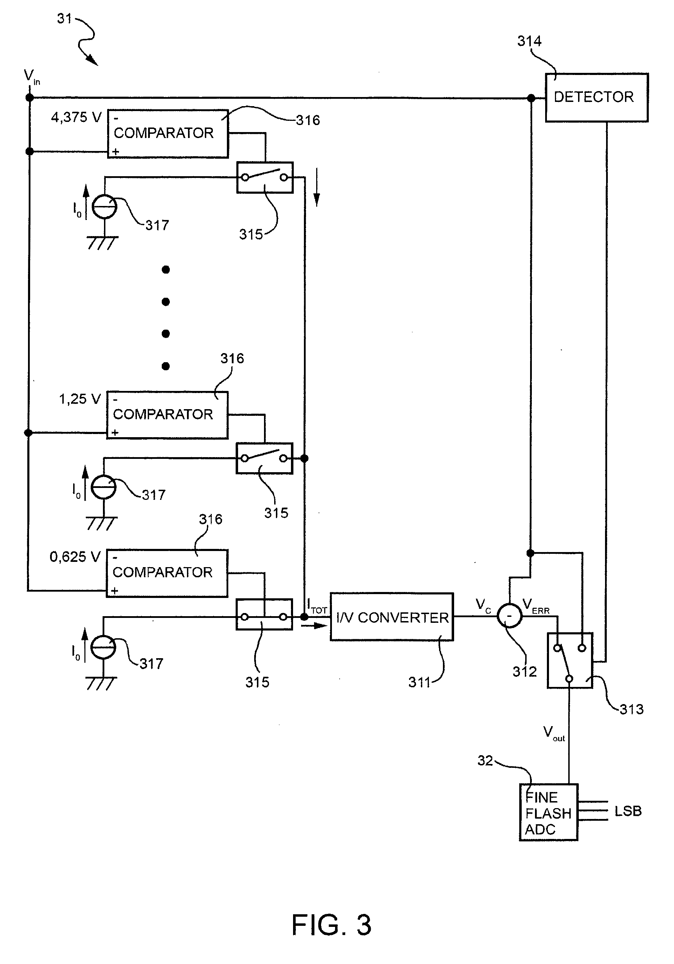

Figure 3 shows a functional block diagram that illustrates an analog pre-processor for ADCs according to a first preferred embodiment of the present invention, said analog pre-processor shown in Figure 3 being designated as a whole by 31.

In particular, the analog pre-processor 31 shown in Figure 3 is designed for being used in an ADC that is configured for converting values of an input voltage that can range between 0 V and 5 V into corresponding digital words each of which comprises:

- N=3 most significant bits (MSBs) obtained via a coarse quantization on $2^N=8$ quantization levels based upon a predefined coarse-quantization voltage $V_q=0.625$ V; and
- M=3 least significant bits (LSBs) obtained via a fine quantization on $2^M=8$ quantization levels based upon a predefined fine-quantization voltage.

As shown in Figure 3, the analog pre-processor 31 receives at input the voltage $V_{IN}$ that is to be converted by said ADC (for simplicity not shown in Figure 3) and supplies at output a voltage $V_{OUT}$, which is then converted by a fine flash ADC 32 into the 3 LSBs.

In particular, the analog pre-processor 31 comprises:

- $2^N-1=7$ channels, each of which is configured for receiving the input voltage $V_{IN}$ (for simplicity in Figure 3 just three channels are explicitly shown, it remaining understood that the four channels not shown explicitly in Figure 3 are, as regards structure and functionalities, equivalent to the three channels shown explicitly) and for generating a respective current on the basis of the input voltage $V_{IN}$;
- a current/voltage (I/V) converter 311, which is coupled to the channels for receiving a current $I_{TOT}$ resulting from the sum of the currents generated by said channels, and is configured for converting the current $I_{TOT}$ into a corresponding voltage $V_c$;
- a subtractor node 312, which is coupled to the I/V converter 311 for receiving the voltage $V_c$, and is configured for subtracting from the input voltage $V_{IN}$ the voltage $V_c$, thus obtaining a voltage $V_{ERR}$;
- an output switch 313, which receives the input voltage $V_{IN}$, is coupled to the subtractor node 312 and to the fine flash ADC 32, and can be actuated for supplying to the fine flash ADC 32 a voltage $V_{OUT}=V_{IN}$ or a voltage $V_{OUT}=V_{ERR}$; and
- a detector 314, which is configured for receiving the input voltage $V_{IN}$ and for actuating the output switch 313 on the basis of the input voltage $V_{IN}$.

In detail, the detector 314 is configured for:

- detecting whether the input voltage $V_{IN}$ is comprised between 0 V and the coarse-quantization voltage Vq=0.625 V;
- if it detects that the input voltage $V_{IN}$ is comprised between 0 V and the coarse-quantization voltage Vq=0.625 V, actuating the output switch 313 in such a way that it will supply to the fine flash ADC 32 the voltage $V_{OUT}=V_{IN}$; and
- if it detects that the input voltage $V_{IN}$ is not comprised between 0 V and the coarse-quantization voltage $V_q=0.625$ V, actuating the output switch 313 in such a way that it will supply to the fine flash ADC 32 the voltage $V_{OUT}=V_{ERR}$.

Moreover, each channel comprises:

- a respective switch 315, which can be opened or closed;
- a respective comparator 316, which receives on a respective first input (designated in Figure 3 by +) the input voltage $V_{IN}$, is coupled to said respective switch 315 and is configured for:

    - comparing said input voltage $V_{IN}$ with a respective reference voltage that is present on a respective second input (designated in Figure 3 by -) and is a respective multiple of the coarsequantization voltage $V_q$,
    - opening said respective switch 315 if the input voltage $V_{IN}$ is lower than the respective reference voltage, and
    - closing said respective switch 315 if the input voltage $V_{IN}$ is higher than the respective reference voltage; and

- a respective current generator 317, which is configured for generating a respective current $I_0$ that has a predefined value and is supplied at output by said channel only if the respective switch 315 is closed.

In greater detail, the seven channels include:

- a first channel (shown explicitly in Figure 3), in which the respective comparator 316 closes the respective switch 315 and hence causes supply at output of the respective current $I_0$ only if the input voltage $V_{IN}$ is greater than 0.625 V, i.e., the respective reference voltage Vq;
- a second channel (shown explicitly in Figure 3), in which the respective comparator 316 closes the respective switch 315 and hence causes supply at output of the respective current $I_0$ only if the input voltage $V_{IN}$ is higher than 1.25 V, i.e., the respective reference voltage 2Vq;
- a third channel (not shown explicitly in Figure 3), in which the respective comparator closes the respective switch and hence causes supply at output of the respective current $I_0$ only if the input voltage $V_{1N}$ is higher than 1.875 V, i.e., the respective reference voltage 3Vq;
- a fourth channel (not shown explicitly in Figure 3), in which the respective comparator closes the respective switch and hence causes supply at output of the respective current $I_0$ only if the input voltage $V_{IN}$ is higher than 2.5 V, i.e., the respective reference voltage 4Vq;
- a fifth channel (not shown explicitly in Figure 3), in which the respective comparator closes the respective switch and hence causes supply at output of the respective current $I_0$ only if the input voltage $V_{IN}$ is higher than 3.125 V, i.e., the respective reference voltage 5Vq;
- a sixth channel (not shown explicitly in Figure 3), in which the respective comparator closes the respective switch and hence causes supply at output of the respective current $I_0$ only if the input voltage $V_{IN}$ is higher than 3.75 V, i.e., the respective reference voltage 6Vq; and
- a seventh channel 312 (shown explicitly in Figure 3), in which the respective comparator 316 closes the respective switch 315 and hence causes supply at output of the respective current $I_0$ only if the input voltage $V_{IN}$ is higher than 4.375 V, i.e., the respective reference voltage $7V_q$.

The currents $I_0$ that are supplied at output by the channels add up in the total current $I_{TOT}$, which has a value equal to $K \cdot I_0$ where K is the number of activated channels (in particular, K is always comprised between 0 and 7), i.e., the ones in which the respective switch 315 is closed. The total current $I_{TOT}$ is supplied at input to the I/V converter 311, which converts it into the voltage $V_c$ having a value equal to $K \cdot V_q$. As described previously, the subtractor node 312 hence subtracts the voltage $V_c$ from the input voltage $V_{IN}$, thus obtaining the voltage $V_{ERR}$, which is hence indicative of the quantization error committed by the ADC in the coarse quantization, i.e., A/D conversion, of the input voltage $V_{IN}$.

As described previously, if the input voltage $V_{IN}$ is comprised between 0 V and the coarse-quantization voltage Vq, the analog pre-processor 31 supplies to the fine flash ADC 32 for the fine quantization of the input voltage $V_{IN}$ the voltage $V_{OUT}=V_{IN}$. If, instead, the input voltage $V_{IN}$ is not comprised between 0 V and the coarse-quantization voltage Vq, the analog pre-processor 31 supplies to the fine flash ADC 32 for the fine quantization of the input voltage $V_{IN}$ the voltage $V_{OUT}=V_{ERR}$.

To explain operation of the channels more clearly, the switches 315 are closed and opened according to the values obtained via coarse quantization of the input voltage $V_{IN}$. In fact, as described previously, the reference voltages of the comparators 316 of the channels are values that are multiples of the coarse-quantization voltage $V_q$. The extreme values are those for which the A/D converter in which the analog pre-processor 31 is used is designed. In particular, as previously described, the A/D converter in which the analog pre-processor 31 is used is designed for converting input voltages $V_{IN}$ that range between 0 V and 5 V. When the value of the input voltage $V_{IN}$ reaches a multiple of the coarse-quantization voltage Vq, i.e., a specific reference voltage, the switches 315 of the channels in which the comparators 316 compare the input voltage $V_{IN}$ with reference voltages equal to or lower than said specific reference voltage are closed. Closing of each switch 315 causes passage of a current $I_0$ that adds to those of the other activated channels. The resulting total current $I_{TOT}$ is converted by the I/V converter 311 into the voltage $V_c$ that represents the coarsely quantized value, and is hence affected by the coarse-quantization error, of the input voltage $V_{IN}$. The difference between $V_{IN}$ and $V_c$ always returns a voltage comprised between 0 V and the coarse-quantization voltage $V_q$, a value that will then be sent to the fine flash ADC 32, which will return the 3 LSBs.

The analog pre-processor 31 can be used in an A/D converter, which comprises:

- a 3-bit flash ADC for coarse quantization of the input voltage $V_{IN}$; or else
- an encoder, for example based upon the use of diodes, configured for generating the 3 MSBs on the basis of the signals, in particular the electrical voltages, with which the comparators 316 drive the respective switches 315.

It should be emphasized that the reasoning previously presented for the analog pre-processor 31 that is to be used in an A/D converter with 3-bit coarse quantization and 3-bit fine quantization can be extended, without this implying any loss of generality, to any one number of bits.

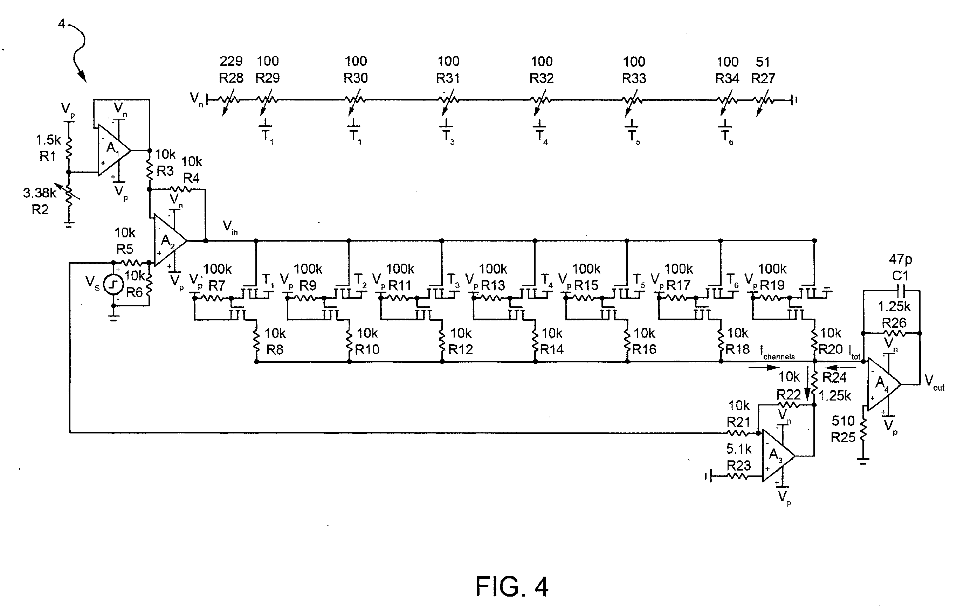

Figure 4 shows a circuit diagram, which represents an analog pre-processor for ADCs according to a second preferred embodiment of the present invention, said analog pre-processor shown in Figure 4 being designated as a whole by 4.

In particular, the analog pre-processor 4 shown in Figure 4 is designed for being used in an ADC that is configured for converting values of an input voltage that can range between 0 V and 5 V into corresponding digital words, each of which comprises:

- N=3 most significant bits (MSBs) obtained via a coarse quantization on $2^N=8$ quantization levels based upon a predefined coarse-quantization voltage $V_q=0.625$ V, and
- M least significant bits (LSBs) obtained via a fine quantization on $2^M$ quantization levels based upon a predefined fine-quantization voltage, with M equal to, or greater than, one.

As shown in Figure 4, the analog pre-processor 4 comprises:

1) a first stage, which, in turn, comprises:

- a buffer $A_1$, which supplies at output a voltage generated on a divider constituted by a resistance $R_1$ and by a variable resistor $R_2$; this voltage is necessary, as will be described in what follows, for proper biasing of the transistors of the channels; and
- an operational amplifier $A_2$ in differential configuration, which receives at input, on the non-inverting pin, the voltage to be converted $V_S$ and, on the inverting pin, the voltage supplied at output by the buffer $A_1$; the operational amplifier $A_2$ supplies at output a voltage $V_{in}$ that is the voltage $V_S$ downshifted by the value fixed by the buffer $A_1$;

2) a second stage, which comprises $2^N-1=7$ channels, or NMOS-PMOS blocks, each of which includes a respective pair of N-P MOSFETs, which function as switches, opening and closing according to the relations between the voltages applied on their terminals; in the absence of input signals the two transistors are in the cut-off region; as the voltage $V_{in}$ applied to the gate electrode (hereinafter called "gate" for simplicity of description) of the NMOS increases, the voltage between the gate and the source electrode (hereinafter referred to as "source" for simplicity of description) $V_{GS}$ rises, and, when a threshold voltage $V_{TH}$ is exceeded, the NMOS passes from the cut-off region to the saturation region; this transition causes a lowering of the voltage on the drain electrode (hereinafter called "drain" for simplicity of description) of the NMOS transistor, which, given that it is connected to the gate of the PMOS, leads to a transition also said PMOS from the cut-off region to the saturation region connecting a voltage Vp of 5 V to a resistance of 10 k$\Omega$; each NMOS-PMOS elementary block hence enables supply of a current equal to 0.5 mA; reference voltages $T_{1...N}$ enable fixing of the correct value of the transition of the NMOS transistor, and, by choosing voltages linked to values that are multiple of the coarse-quantization value $V_q$, triggering of each channel occurs only when the voltage $V_{in}$ reaches the value of the voltage multiple of the one associated to that channel, activating the channels in cascaded fashion; there is thus generated a current staircase with a number of steps equal to the number of "quanta" overstepped by the input signal;

3) a third stage, which comprises an amplifier $A_3$, in inverting configuration, which generates via a resistance $R_{24}$ a current proportional to the voltage value of the analog signal to be converted; this current has a value and a sense such as to be subtracted from the one generated by the channels of the second stage; and

4) a fourth stage, which comprises an amplifier $A_4$, in current/voltage-converter configuration, which converts the current resulting from the currents generated by the second and third stages into a voltage to be sent to the next A/D fine conversion.

In what follows, operation of the individual components and stages of the analog pre-processor 4 will be described in detail always assuming, for simplicity of description, that the voltage $V_S$ to be converted is a ramp with dynamic range between 0 V and 5 V.

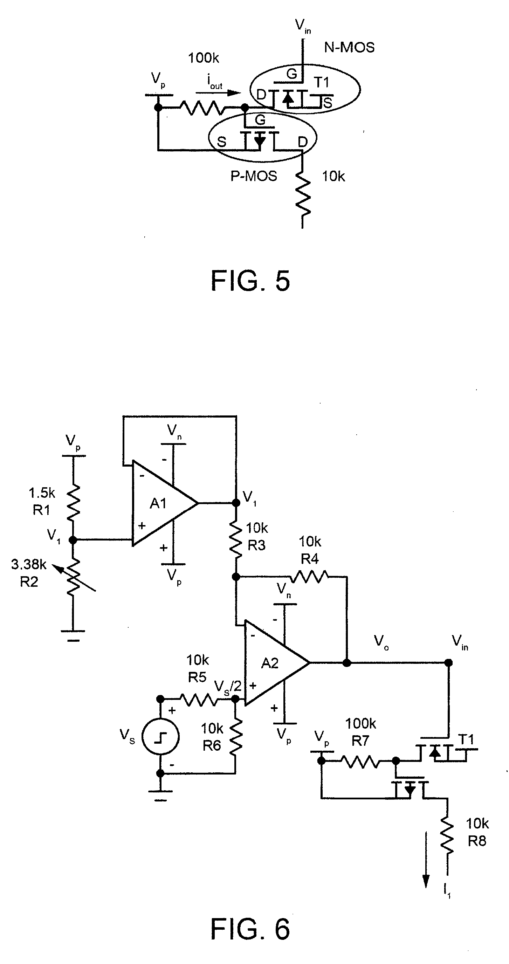

In particular, there is first described in detail operation of the first NMOS-PMOS elementary block, i.e., of the first channel (i.e., the first in the switching sequence), which comprises two MOSFETs, one with N channel and one with P channel, and is shown in detail in Figure 5.

According to the second preferred embodiment of the present invention, the only regions of operation of the MOSFETs that are exploited are the saturation and cut-off regions.

As described previously, the analog signal to be converted is represented by the voltage $V_S$, which can assume values comprised between 0 V and 5 V. The voltage $V_{in}$ applied to the gates of the NMOSs, in particular to the gate of the NMOS shown in Figure 5, as will be explained in detail in what follows, is a downshifted version of said voltage $V_S$.

As shown in Figure 5, the resistance between the positive supply $V_P$ and the drain of the N-channel transistor has been chosen equal to 100 kΩ in such a way as to have a very low output current and affect as little as possible the reference voltage $T_1$ applied to the source. In addition, since the transconductance is defined as $g_m = i_{out}/V_{in}$, the lower the output current $i_{out}$, the lower the swing of the driving voltage $V_{in}$. A further advantage is to have reduced consumption levels.

With reference to the NMOS shown in Figure 5, it behaves as an open circuit (cut-off region) as long as the voltage drop $V_{GS}$ between the gate and the source is lower than the threshold voltage $V_{TH}$, which is positive for the N-channel MOS, whereas it goes into saturation (switch closed) for values of $V_{GS}$ higher than the $V_{TH}$.

The PMOS shown in Figure 5 is in the saturation region for values of $V_{GS}$ lower than $V_{TH}$, which is negative for P-channel MOSs, and in cut-off for values of $V_{GS}$ higher than $V_{TH}$.

In other words, the transistors function as switches that open and close according to the relations between the voltages applied on their terminals. In the testing circuit provided by the present applicant, the threshold voltages are approximately 0.91 V and -0.91 V respectively for the NMOS and the PMOS. The reference voltage Ti, i.e., the voltage applied to the source of the N-channel transistor, is a negative voltage appropriately generated by a voltage divider (not shown in Figure 5). The analysis of this reference voltage and of the voltages of the blocks subsequent to the first will be presented in the following. For the moment it is pointed out that, to guarantee a sequential activation of the NMOS-PMOS elementary blocks (from the first to the last), the input voltage $V_{in}$ is obtained by shifting the voltage to be converted $V_S$ by a certain negative amount. To carry out this shifting of the signal, the first stage of the analog pre-processor 4 is used, said first stage being shown in detail in Figure 6.

In particular, as shown in Figure 6, via a resistive divider the positive supply voltage Vp is shared between the resistances $R_1$ and $R_2$. The voltage $V_1$ on $R_2$ is a positive voltage applied to the non-inverting terminal of the operational amplifier $A_1$ that is in buffer configuration. Thanks to its high input impedance and to the low output impedance, $V_1$ is brought without variations to the output of the buffer by shortcircuiting the latter with the inverting terminal of the amplifier $A_1$. In order to determine the output voltage of the first stage $V_o$ the differential amplifier $A_2$ is used. Using the superposition principle, $V_o$ is decomposed into the sum of two voltages

$$V_o = V_{o1} + V_{o2}$$

where

$$V_{o1} = -(R_4/R_3) \; V_1 = -V_1$$

and

$$V_{o2} = (1+R_4/R_3) \; V_S = 2V_S$$

Since the signal $V_S$ is amplified by a factor of two, it should be halved using the resistive divider formed by $R_5$ and $R_6$, which are chosen of the same value. In this way, the total output voltage of the first stage $V_o$ is

$$V_o = V_{o1} + V_{o2} = 2V_S \; R_6/(R_6+R_5) \; - \; V_1 = V_S - V_1$$

The output of the amplifier $A_2$ is connected to the inputs of the channels, and for this reason $V_o$ corresponds to the $V_{in}$ introduced previously. At input to the channels we will consequently have a version shifted in amplitude by a negative amount of the analog input signal $V_S$ to be converted.

Once again with reference to Figure 6, the signal $V_{in}$ is applied to the gate of the NMOS. When $V_{GS} > V_{TH}$ there is closing of the switch constituted by the N-channel MOSFET. Said switching from the cut-off region to the saturation region causes a reduction of the voltage on the drain of the transistor of the first channel, from a value of 5 V (given by the positive supply $V_P$) to a value of approximately -3.7 V. In this situation, since the drain of the NMOS is connected to the gate of the PMOS, the P-channel transistor, which up to that moment was in the cut-off region since the gate voltage and the source voltage were at the same potential $V_P$ of the positive supply, switches by passing into the saturation region and enabling the drain voltage, connected to the 10 kΩ resistance, to pass from a value of 0 V to a value of 5 V.

Consequently, the output voltage of the NMOS-PMOS elementary circuit block, taken on the drain of the P-channel transistor, is 5 V and, thanks to the 10 kΩ resistance, the output current supplied by the branch connected to the drain of the PMOS is 0.5 mA. Each PMOS-NMOS elementary block has hence the purpose of supplying a current equal to 0.5 mA. The input voltage range of interest varies from 0 to 5 V. The coarse quantization on 3 bits envisages $2^3=8$ quantization levels that are multiples of 0.625 V. This implies that the A/D conversion will have to return a staircase output voltage with a jump between each step of 0.625 V.

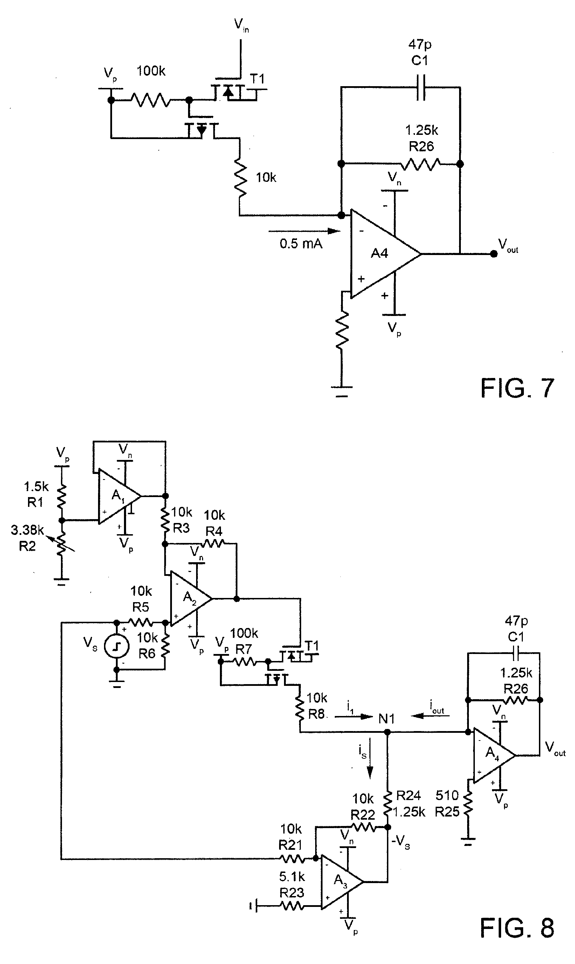

To do this there is provided at output, i.e., in the fourth stage of the analog pre-processor 4, which is shown in detail in Figure 7, an operational amplifier $A_4$ with feedback resistance $R_{26}$ of a value equal to 1.25 kΩ and a capacitance $C_1$ of 47 pF. The task of the operational amplifier $A_4$ is to maintain the voltage zero on the inverting terminal, thus avoiding undesirable voltage drops and hence variations of the current supplied by the individual NMOS-PMOS circuit block.

Once again with reference to Figure 7, the output voltage will be equal to

$$V_{out} = R_{26} \cdot I_1 = -1.25 \text{ k}\Omega \cdot 0.5 \text{ mA} = -0.625 \text{ V}$$

The result indicates how, for a current of 0.5 mA, the output returns a voltage equal to -0.625 V. Each NMOS-PMOS active block contributes with a current of 0.5 mA that adds to the other currents, which have the same value, of the other active blocks. If, for example, it were necessary to activate the first two NMOS-PMOS blocks, we would have a current of 1 mA at input and hence an output voltage of -1.25 V, and so on. $V_{out}$ will be a staircase voltage with jumps, between one step and the previous one, having values equal to multiples of -0.625 V.

When the signal to be converted $V_S$ reaches a value equal to 0.625 V, the first block is activated and, hence, a current equal to 0.5 mA is supplied to the feedback resistance of the amplifier at output and generates a negative voltage of - 0.625 V.

Rather than the conversion of the signal, what is important is the calculation of the error committed in the coarse quantization of $V_S$, which, in what follows, will be called, for simplicity of description, also coarse-quantization error. Another operational amplifier in inverting configuration will hence be necessary. The circuit that supplies the calculation of the quantization error in the case of a single NMOS-PMOS elementary block is the one given in Figure 8, represented in which are also the first stage, the third stage, and the fourth stage of the analog pre-processor 4.

Consequently, with reference to Figure 8, the inverting amplifier $A_3$ has the task of inverting the voltage $V_S$ and hence returning at output a negative voltage signal ($-V_S$), which, thanks to the 1.25 kΩ resistance $R_{24}$, generates a current $I_S$ coming out from the node $N_1$. This current is then subtracted from the current $I_1$ and their difference supplies the current $I_{out}$ entering the node $N_1$. The output voltage $V_{out}$ will be given by the current $I_{out}$ that flows through the 1.25 kΩ feedback resistance $R_{26}$ of the operational amplifier $A_4$. This is equivalent to saying that the voltage $V_{out}$ that represents the error of the coarse conversion of $V_S$ is nothing but the subtraction between the voltage generated by $I_S$ on $R_{26}$ and the voltage generated by $I_1$ on the same resistance, i.e., the difference between the voltage $V_S$ and the staircase voltage given by the coarse analog-to-digital conversion. It may be understood how the staircase voltage given by the A/D conversion subtracted from the voltage $V_S$ generates a saw-toothed signal corresponding to the coarse-quantization error having an amplitude of 0.625 V.

In what follows, it will be explained why at input to the gates of the NMOSs a voltage $V_{in}$ is used that does not correspond to the voltage $V_S$ at input to the A/D converter, but rather to an amplitude shift thereof by a negative amount. It may be noted how in the folding apparatus of Figure 4 the last NMOS-PMOS elementary circuit block, where by the word "last" is meant the last in order of activation, will have the source of the N-channel transistor connected to ground. In fact, to cause supply of a current $I_{out}$ equal to 0.5 mA, the voltage between the gate and the source of the NMOS, must be higher than the threshold voltage thereof, i.e., $V_{GS}>V_{TH}$, but the gate voltage $V_G$ corresponds to the voltage $V_{in}$ and the voltage on the source $V_{source}$ is zero. Hence, we must find

$$V_{in} - V_{source} > V_{TH} \rightarrow V_{in} - 0 > V_{TH} \rightarrow V_{in} > V_{TH}$$

As soon as the input voltage on the gate exceeds the threshold voltage of the N-channel transistor, there is activation of the last NMOS-PMOS circuit block. The threshold voltage of the MOSFET in question is approximately equal to 0.91 V. This implies that for $V_{in} > 0.91$ V the N-channel transistor goes into conduction, and, at the same time, enables the P-channel transistor to switch from the cut-off region to the saturation region.

Hereinafter, for clarity of description, the voltages at the source of the N-channel MOSFET will be designated by $T_n$ (n = 1, 2, ..., 6).

If, at input to the gate, $V_S$ were applied directly, the last PMOS-NMOS block would be activated at values of $V_S$ higher than 0.91 V, i.e., for

$$V_S - 0 > V_{TH} \rightarrow V_S > V_{TH}$$

We shall now assume that the blocks preceding the aforesaid block, present positive reference voltages $T_n$ on the sources of the NMOSs. The latter will then switch from the cut-off region to the saturation region if

$$V_S - T_n > V_{TH} \rightarrow V_S > V_{TH} + T_n$$

As soon as the input voltage $V_S$ on the gate exceeds the threshold voltage $V_{TH}$ added to the source voltage $T_n$, the n-th NMOS-PMOS block is activated. Since $V_{TH} < V_{TH} + T_n$, the last channel will be activated at voltages $V_S$ lower than those of all the others. But this must not happen since the sequentiality of activation of the individual channels must be respected. When previously operation of the individual NMOS-PMOS elementary circuit block was described, it was said that, since the converter is a three-bit converter, the possible conversion levels are $2^3=8$, and, since it is always assumed that the voltage $V_S$ is a ramp from 0 V to 5 V, we should find levels that are multiples of 0.625 V. The first block must hence be activated for $V_S$ = 0.625 V, the second block for $V_S$ = 1.25 V, until we arrive at the seventh and last block, which will be activated for

$$V_S = 0.625 \ V \cdot 7 = 4.375 \ V$$

This is possible only if reference negative voltages $T_n$ are adopted; in fact, if we add to the positive voltage $V_{TH}$ a negative voltage $T_n$ we will have

$$V_{TH} > V_{TH} + T_n$$

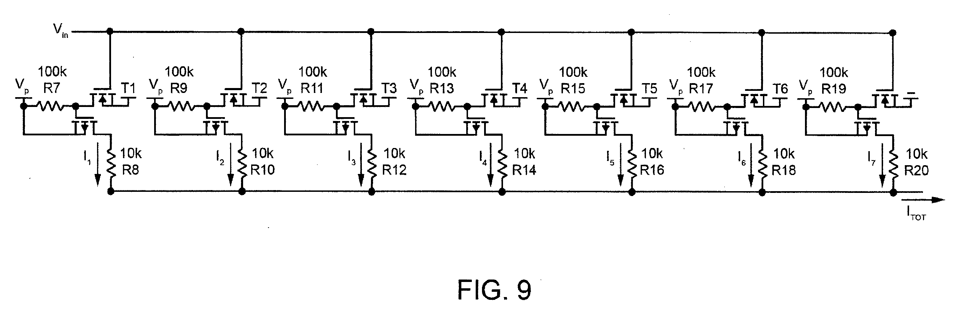

The voltage $V_{GS}$ of the NMOSs, necessary for activation of the individual channels, will have to be equal to $V_{TH}$ for the last channel, whereas it will have to be equal to $V_{TH}+T_n$, with $T_n$ negative, for the previous ones. It is thus evident how the NMOS-PMOS block with the source of the N-channel transistor connected to ground, is the last in the order of activation.
The reference voltages $T_n$ can be obtained using variable resistances set in series to one another and connected to a negative supply $V_n$.
Following upon the analysis made so far, it is possible to understand the reason why the voltage $V_S$ cannot be applied directly to the gates of the NMOSs. In fact, starting from 0 V and arriving at 5 V, it causes a premature switching of all those MOSFETs that have a voltage $T_n$ on their source lower than zero by an amount equal to at least 0.91 V. For this reason the input voltage on the gates of the N-channel transistors, designated by $V_{in}$, does not correspond to $V_S$, but rather to an amplitude shift by a negative amount of approximately -3.5 V. However, the dynamic range of the signal remains unvaried. $V_{in}$ will still be a ramp, but from -3.5 V to 1.5 V. In this way, each channel will be activated only after the one that precedes it is found to be active, or, more precisely, at an input voltage equal to a multiple of 0.625 V. As shown in Figure 4, the complete circuit comprises seven NMOS-PMOS elementary circuit blocks, i.e., seven channels, each of which has the task of supplying, if active, a current equal to 0.5 mA.
As shown in Figure 9, the total current when all seven channels are active is

$$I_{tot} = I_1 + I_2 + I_3 + I_4 + I_5 + I_6 + I_7 = 3.5 \ mA$$

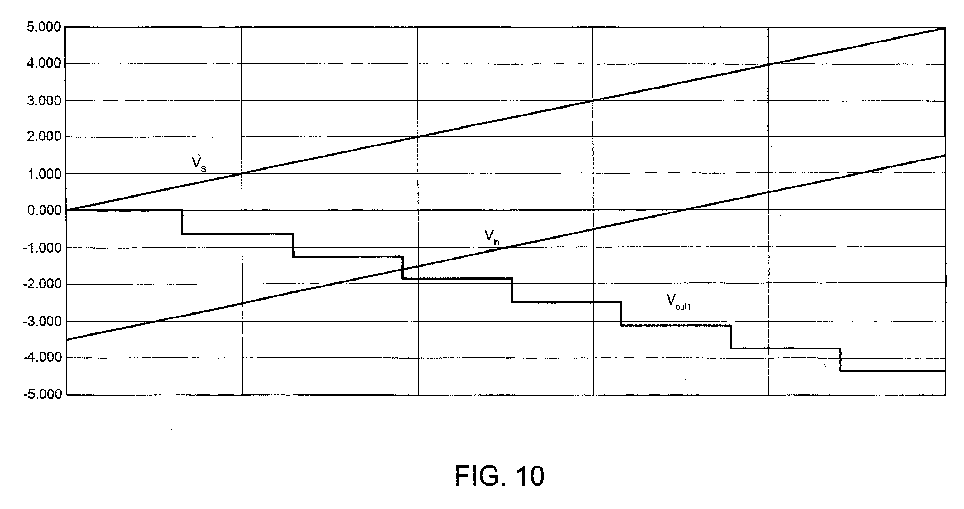

Since, as may be seen from the analysis of the individual NMOS-PMOS elementary block, each current of 0.5 mA contributes to a jump in the output voltage of -0.625 V, $V_{out}$ will have a staircase pattern. In this regard, Figure 10 shows a graph that represents the ramp pattern of the voltage to be converted $V_S$, the corresponding plot of the input voltage at the gates $V_{in}$ and the corresponding plot of the output voltage $V_{out1}$ generated only on the basis of the total current $I_{tot}$ produced by the seven channels.

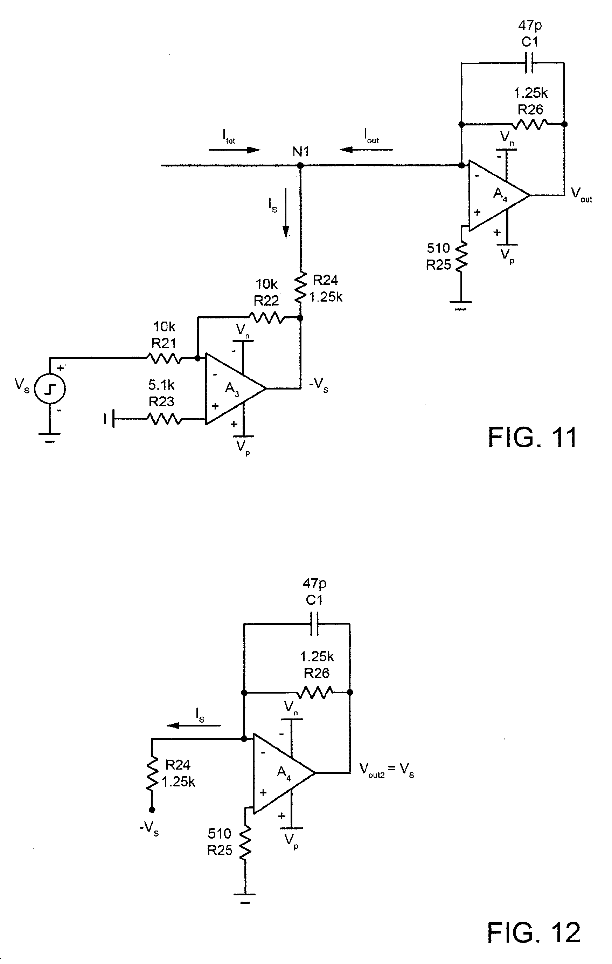

With reference now to the circuit shown in Figure 11, in order to calculate the coarse-quantization error, as has been seen in the case of a single channel, it is necessary to use an operational amplifier in inverting configuration that has unit gain.

The voltage at output from $A_3$ will be

$$V_S \cdot (-R_{22}/R_{521}) = V_S \cdot (-10k\Omega/10k\Omega) = -V_S.$$

That is, the input ramp has been inverted. The voltage $-V_S$, applied to the resistance $R_{24}$, generates a current $I_S$ coming out of the node $N_1$. The equation at said node is

$$I_{out} + I_{tot} - I_S = 0 \rightarrow I_{out} = I_S - I_{tot}$$

The output current, namely, the current that determines the output voltage via the feedback resistance $R_{26}$, is given by the difference between the current generated by the signal $-V_S$ applied to $R_{24}$ and the total current supplied by the active channels. It is thus possible to divide the voltage $V_{out}$ into two contributions, one given by $I_{tot}$ and the other by $I_S$, which will be designated, respectively, by $V_{out1}$ (in accordance with the notation previously introduced and used in Figure 10) and $V_{out2}$. As regards the first contribution we will have

$$V_{out1} = -2 \ I_{tot} \ R_{26} = V_{tot}$$

Namely, $I_{tot}$ contributes at output with a negative voltage that will be designated by, for simplicity, $V_{tot}$.

With reference to the circuit of Figure 12 in order to analyse the second contribution due to the current $I_S$, it should be noted that the resistances $R_{24}$ and $R_{26}$ are traversed by the same current. The current is determined by

$$I_S = [0-(-V_S)]/R_{24} = V_S/R_{24}$$

The voltage $V_{out2}$ will thus be

$$V_{out2} = I_S \cdot R_{26} = V_S \cdot R_{26}/R_{26} = V_S$$

The total output voltage $V_{out}$ will be nothing other than

$$V_{out} = V_{out1} + V_{out2} = V_{tot} + V_S$$

We here wish to recall that $V_{tot}$ is a negative staircase voltage.

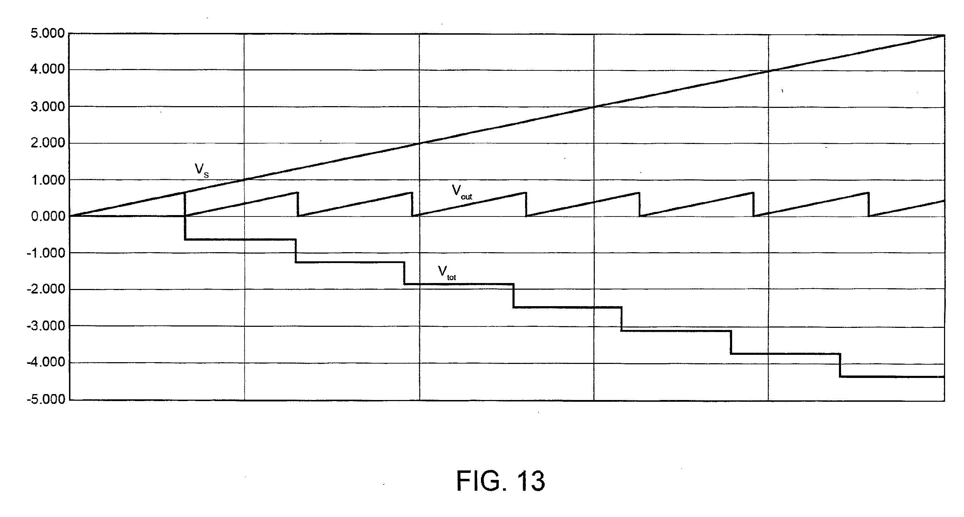

Figure 13 shows a graph that illustrates the ramp plot of the voltage to be converted $V_S$, the corresponding plot of the voltage $V_{tot}$ generated only on the basis of the total current $I_{tot}$ produced by the seven channels, and the corresponding plot of the output voltage $V_{out}$.

As shown in Figure 13, $V_{out}$ is a saw-toothed voltage corresponding to the quantization error committed in the coarse quantization on 3 bits of $V_S$. The peak levels reached by each individual tooth have a value equal to 0.625 V.

Finally, the analog pre-processor 4 can be used in an A/D converter that comprises:

- a 3-bit flash ADC for coarse quantization of the input voltage $V_{IN}$; or else
- an encoder, for example based upon the use of diodes, configured for generating the 3 MSBs on the basis of the voltages present on the drains of the PMOSs of the channels.

It should be emphasized that the arguments previously presented for the analog pre-processor 4 that is to be used in an A/D converter with coarse quantization on 3 bits can be extended, without any loss of generality, to any number of bits.

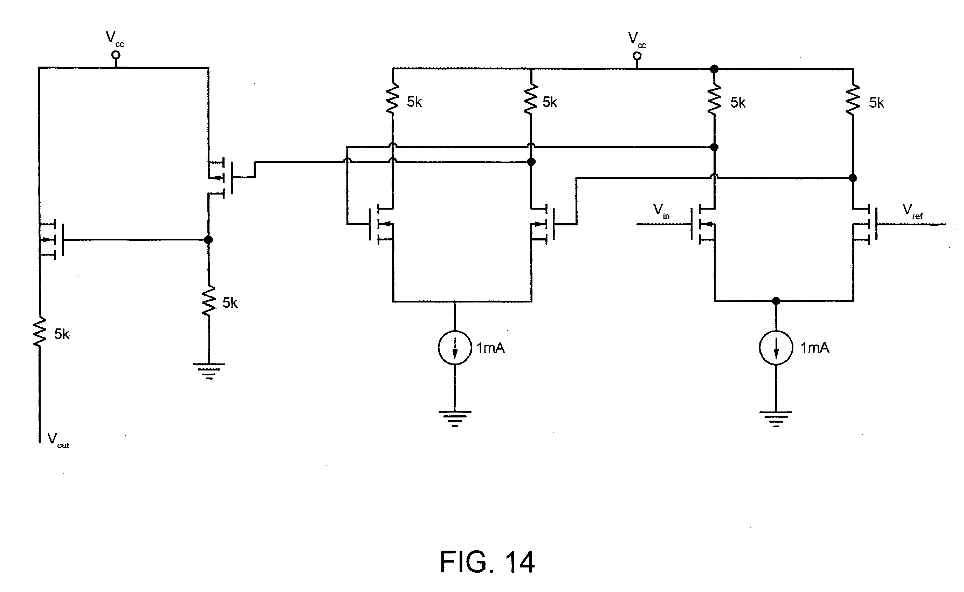

In addition, it should also be emphasized that the present invention can be obtained using other embodiments different from the ones shown in Figures 3 and 4 and described previously. For example, the present invention can be obtained also using channels based upon differential pairs and current mirrors. In this regard, represented in Figure 14 is an embodiment of a single channel that is based upon a differential pair and current mirror.

In particular, as shown in Figure 14, a first differential pair is used for carrying out subtraction between the input signal and the reference voltage. Inserted downstream of this is a second differential pair that increases the speed of response of the system, increasing, however, the circuit complexity and the consumption levels. A small difference of the order of tens of millivolts enables passage from the positive saturation (response of the differential pair if the input signal is lower than the reference voltage) to the negative saturation (response of the differential pair if the input signal is higher than the reference voltage). The voltage at output from the differential pair changes from high to low when the threshold voltage is exceeded by the input; this enables driving of a transistor that, if it is set in conduction, enables passage of a current of a pre-set value.

From the foregoing description the advantages of the present invention may be immediately appreciated.

In particular, it should be emphasized that the present invention makes it possible to:

- reduce the number of components as compared to a flash ADC architecture, a classic architecture of a subranging type, and a classic architecture of a folding type;
- implement easily the analog pre-processing circuit both in discrete technology and in integrated technology because just a few components readily available on the market are used, such as, for example, operational amplifiers and NMOSs and PMOSs with substrate attached to the source, or ones that can be readily obtained in integrated technology;
- reduce the consumption levels of the A/D converters; in fact, the operational amplifiers are the components with highest consumption levels in an ADC, and the total number of operational amplifiers used by the present invention is much lower than in a flash ADC; moreover, in the second preferred embodiment of the present invention, MOSFET amplifiers are exploited with lower gain, which further reduce the consumption levels;
- increase the rate of conversion of the ADC; in fact, eliminating the DAC and the adder node of a classic subranging ADC, it is possible to increase the speed of conversion so as to reach almost the speed of a flash ADC; in fact, assuming that the times of conversion of the two flash subranging ADCs are the same, the present invention only adds the time of switching of the switches; and
- eliminate the first coarse flash ADC of a classic subranging/folding ADC thus avoiding the use of $2^N-1$ comparators; in fact, the present invention, as previously described, enables use of an encoder for coarse quantization.

In other words, the analog pre-processing circuit according to the present invention enables reduction of the costs of production of the A/D converters of a folding type, increase of their speed and bandwidth, as well as reduction of the power consumption thereof.

Moreover, the analog pre-processing circuit according to the present invention can be advantageously exploited in all digital signal-acquisition chains and in particular in radiofrequency testing apparatuses, in low-speed sampling oscilloscopes and in external data-acquisition systems for personal computers.

**Claims**

1. An analog pre-processor (4) for analog-to-digital converters configured for converting an input voltage into a digital word comprising N bits indicating a quantized value that is obtained via a quantization on $2^N$ levels of the input voltage and is affected by a quantization error, where N is an integer equal to, or higher than, one;
   the analog pre-processor (4) comprising:

   • an input stage designed for receiving the input voltage and configured for generating a driving voltage indicating said input voltage;
   • $2^N-1$ channels, each of which is designed for receiving the driving voltage and is configured for generating a respective electric current if said driving voltage exceeds a respective reference voltage linked to a corresponding quantization level; and
   • an output stage designed for receiving the input voltage and configured for generating an output voltage indicating the quantization error on the basis of the input voltage and of the electric currents generated by the channels; and **characterised in that**:

each channel comprises a respective PMOS transistor and a respective NMOS transistor, which includes a gate electrode designed for receiving the driving voltage, a source electrode connected to the respective reference voltage, and a drain electrode connected to a gate electrode of the respective PMOS transistor, in such a way that:

• if the driving voltage does not exceed the respective reference voltage, said respective NMOS and PMOS transistors will be both in cut-off and said channel will not generate the respective electric current; and,

• if the driving voltage exceeds the respective reference voltage, said respective NMOS and PMOS transistors will be both in saturation and said channel will generate the respective electric current through a drain electrode of the respective PMOS transistor.

2. The analog pre-processor of Claim 1, wherein:

• the quantization on $2^N$ levels of the input voltage is based upon a predefined quantization voltage;
• the reference voltage of each channel is linked to a corresponding multiple of the predefined quantization voltage; and
• the electric currents generated by the channels all have one and the same predefined value.

3. The analog pre-processor according to Claim 1 or Claim 2, wherein in each channel:

• the drain electrode of the respective NMOS transistor is also connected, through a biasing resistance, to a biasing voltage;
• the respective PMOS transistor includes a source electrode directly connected to said biasing voltage; and
• the drain electrode of the respective PMOS transistor is connected to an output resistance of said channel;

wherein in all the channels:

• the biasing voltages have one and the same predefined voltage value;
• the biasing resistances have one and the same first predefined value of resistance; and
• the output resistances have one and the same second predefined value of resistance;

and wherein the output resistances of all the channels are connected together in such a way that the currents generated by the channels through the drain electrodes of the PMOS transistors will add up in a total current that is indicative of the quantized value.

4. The analog pre-processor of Claim 3, wherein the output stage comprises:

• an amplifier in inverting configuration, which is designed for receiving the input voltage, is configured for generating an electric current indicating the input voltage, and is coupled to the output resistances of the channels in such a way that said electric current indicating the input voltage is subtracted from the total current thereby generating an output electric current indicating the quantization error; and
• a current-voltage converter configured for receiving the output electric current and for converting said output electric current into the output voltage.

5. The analog pre-processor according to any one of the preceding claims, wherein the input stage is configured for generating a driving voltage that is lower than the input voltage by a predefined amount.

6. An analog-to-digital converter configured for converting an input voltage into a digital word that comprises N bits indicating a quantized value that is obtained via a quantization on $2^N$ levels of the input voltage and is affected by a quantization error, where N is an integer equal to, or higher than, one; the analog-to-digital converter comprising the analog pre-processor claimed in any one of the preceding claims.

7. The analog-to-digital converter of Claim 6, comprising an encoder configured for:

• acquiring voltages present on the drain electrodes of the PMOS transistors of the channels of the analog pre-processor; and
• generating the N bits of the digital word on the basis of the voltages acquired.

8. The analog-to-digital converter according to Claim 6 or Claim 7, wherein the digital word comprises further M bits and wherein M is an integer equal to, or higher than, one;
the analog-to-digital converter comprising an analog-to-digital converter of a flash type, which is coupled to the analog pre-processor for receiving the output voltage generated by said analog pre-processor and is configured for converting the voltage received by the analog pre-processor into the further M bits of the digital word.

## Patentansprüche

1. Analoger Vorprozessor (4) für Analog-Digital-Wandler, der dafür ausgelegt ist, eine Eingangsspannung in ein digitales Wort umzuwandeln, das N Bits umfasst, die einen quantisierten Wert anzeigen, der durch eine Quantisierung auf $2^N$ Pegeln der Eingangsspannung ermittelt wird und mit einem Quantisierungsfehler behaftet ist, wobei N eine ganze Zahl gleich oder höher als eins ist;
wobei der analoge Vorprozessor (4) Folgendes umfasst:

• eine Eingangsstufe, die dazu bestimmt ist, die Eingangsspannung zu empfangen, und die dafür ausgelegt ist, eine Antriebsspannung zu erzeugen, welche die Eingangsspannung anzeigt;
• $2^N$-1 Kanäle, von denen jeder dazu bestimmt ist, die Antriebsspannung zu empfangen und dafür ausgelegt ist, einen jeweiligen elektrischen Strom zu erzeugen, wenn die Antriebsspannung eine jeweilige Bezugsspannung übersteigt, die mit einem entsprechenden Quantisierungspegel verknüpft ist; und
• eine Ausgangsstufe, die dazu bestimmt ist, die Eingangsspannung zu empfangen und dafür ausgelegt ist, eine Ausgangsspannung zu erzeugen, die den Quantisierungsfehler anzeigt, und zwar basierend auf der Eingangsspannung und den durch die Kanäle erzeugten elektrischen Strömen; und **dadurch gekennzeichnet, dass**:

jeder Kanal einen jeweiligen PMOS-Transistor und einen jeweiligen NMOS-Transistor umfasst, der Folgendes aufweist: eine Gate-Elektrode, die dazu bestimmt ist, die Antriebsspannung zu empfangen, eine Source-Elektrode, die mit der jeweiligen Bezugsspannung verbunden ist, und eine Drain-Elektrode, die mit einer Gate-Elektrode des jeweiligen PMOS-Transistors verbunden ist, derart, dass:

• die jeweiligen NMOS- und PMOS-Transistoren beide gesperrt sind und der Kanal jeweils keinen elektrischen Strom erzeugt, wenn die Antriebsspannung die jeweilige Bezugsspannung nicht übersteigt, ; und
• die jeweiligen NMOS- und PMOS-Transistoren beide gesättigt sind und der Kanal jeweils elektrischen Strom durch eine Drain-Elektrode des jeweiligen PMOS-Transistors erzeugt, wenn die Antriebsspannung die jeweilige Bezugsspannung übersteigt.

2. Analoger Vorprozessor nach Anspruch 1, wobei:

• die Quantisierung der Eingangsspannung auf $2^N$ Pegeln auf einer vordefinierten Quantisierungsspannung basiert;
• die Bezugsspannung jedes Kanals mit einem entsprechenden Vielfachen der vordefinierten Quantisierungsspannung verknüpft ist; und
• die durch die Kanäle erzeugten elektrischen Ströme alle ein und denselben vordefinierten Wert aufweisen.

3. Analoger Vorprozessor nach Anspruch 1 oder Anspruch 2, wobei in jedem Kanal:

• die Drain-Elektrode des jeweiligen NMOS-Transistors durch einen Vorspannungswiderstand auch mit einer Vorspannung verbunden ist;
• der jeweilige PMOS-Transistor eine Source-Elektrode umfasst, die direkt mit der Vorspannung verbunden ist; und
• die Drain-Elektrode des jeweiligen PMOS-Transistors mit einem Ausgangswiderstand des Kanals verbunden ist;

wobei in allen Kanälen:

- die Vorspannungen ein und denselben vordefinierten Spannungswert aufweisen;
- die Vorspannungswiderstände ein und denselben ersten vordefinierten Widerstandswert aufweisen; und
- die Ausgangswiderstände ein und denselben zweiten vordefinierten Widerstandswert aufweisen;

und wobei die Ausgangswiderstände aller Kanäle derart miteinander verbunden sind, dass sich die von den Kanälen durch die Drain-Elektroden der PMOS-Transistoren erzeugten Ströme zu einem Gesamtstrom addieren, der den quantisierten Wert anzeigt.

4. Analoger Vorprozessor nach Anspruch 3, wobei die Ausgangsstufe Folgendes umfasst:

- einen Verstärker in invertierender Konfiguration, der dazu bestimmt ist, die Eingangsspannung zu empfangen, der dafür ausgelegt ist, einen elektrischen Strom zu erzeugen, der die Eingangsspannung anzeigt, und der mit den Ausgangswiderständen der Kanäle derart verbunden ist, dass der elektrische Strom, der die Eingangsspannung anzeigt, vom Gesamtstrom subtrahiert wird, wodurch ein elektrischer Ausgangsstrom erzeugt wird, der den Quantisierungsfehler anzeigt; und
- einen Strom-Spannungs-Wandler, der dafür ausgelegt ist, den elektrischen Ausgangsstrom zu empfangen und den elektrischen Ausgangsstrom in die Ausgangsspannung umzuwandeln.

5. Analoger Vorprozessor nach einem der vorhergehenden Ansprüche, wobei die Eingangsstufe dafür ausgelegt ist, eine Antriebsspannung zu erzeugen, die um ein vordefiniertes Ausmaß niedriger als die Eingangsspannung ist.

6. Analog-Digital-Wandler, der dafür ausgelegt ist, eine Eingangsspannung in ein digitales Wort umzuwandeln, das N Bits umfasst, die einen quantisierten Wert anzeigen, der durch eine Quantisierung auf $2^N$ Pegeln der Eingangsspannung ermittelt wird und mit einem Quantisierungsfehler behaftet ist, wobei N eine ganze Zahl gleich oder höher als eins ist;
wobei der Analog-Digital-Wandler den analogen Vorprozessor nach einem der vorhergehenden Ansprüche umfasst.

7. Analog-Digital-Wandler nach Anspruch 6, umfassend einen Codierer, der dafür ausgelegt ist:

- Spannungen zu erfassen, die an den Drain-Elektroden der PMOS-Transistoren der Kanäle des analogen Vorprozessors vorhanden sind; und
- auf Basis der erfassten Spannungen die N Bits des digitalen Worts zu erzeugen.

8. Analog-Digital-Wandler nach Anspruch 6 oder Anspruch 7, wobei das digitale Wort weitere M Bits umfasst und wobei M eine ganze Zahl gleich oder höher als eins ist;
wobei der Analog-Digital-Wandler einen Analog-Digital-Wandler vom Flash-Typ umfasst, der mit dem analogen Vorprozessor verbunden ist, um die von dem analogen Vorprozessor erzeugte Ausgangsspannung zu empfangen, und der dafür ausgelegt ist, die von dem analogen Vorprozessor empfangene Spannung in die weiteren M Bits des digitalen Worts umzuwandeln.

**Revendications**

1. Un préprocesseur (4) analogique pour convertisseurs analogique-numérique configurés pour convertir une tension d'entrée en un mot numérique comprenant N bits indiquant une valeur quantifiée qui est obtenue par l'intermédiaire d'une quantification à $2^N$ niveaux de la tension d'entrée et est affectée par une erreur de quantification, N étant un nombre entier égal ou supérieur à un; le préprocesseur analogique (4) comprenant:

- Un étage d'entrée conçu pour recevoir la tension d'entrée et configuré pour générer une tension de commande qui indique ladite tension d'entrée;
- $2^N$-1 canaux, dont chacun est conçu pour recevoir la tension de commande et est configuré pour générer un courant électrique respectif si ladite tension de commande dépasse une tension de référence liée à un niveau de quantification correspondant; et
- Une étage de sortie conçu pour recevoir la tension d'entrée et configuré pour générer une tension de sortie indiquant l'erreur de quantification sur la base de la tension d'entrée et des courants électriques générés par les canaux; **caractérisé en ce que**:

Chaque canal comprend un transistor PMOS et un transistor NMOS, qui comprend une électrode de grille destinée à recevoir la tension de commande, une électrode de source connectée à la tension de référence, et une électrode de drain connectés à une électrode de grille du transistor PMOS, de telle sorte que:

- Si la tension de commande n'excède pas la tension de référence, lesdits transistors NMOS et PMOS seront en coupure et ledit canal ne génèrera pas le courant électrique ; et,
- Si la tension de commande excède la tension de référence, lesdits transistors NMOS et PMOS seront en saturation et ledit canal génèrera le courant de référence à travers une électrode de drain du transistor PMOS.

2. Le préprocesseur analogique selon la revendication 1, dans lequel la quantification sur $2^N$ niveaux de la tension d'entrée est basée sur une tension de quantification prédéfinie ; la tension de référence de chaque canal est relié à un multiple correspondant à la tension de quantification prédéfinie ; et les courants électriques générés par les canaux possèdent tous une même valeur prédéfinie.

3. Le préprocesseur analogique selon la revendication 1 ou 2, dans lequel dans chaque canal :

- L'électrode de drain du transistor NMOS est également connectée, par une résistance de polarisation, à une tension de polarisation;
- Le transistor PMOS comprend une électrode de source connectée directement à ladite tension de polarisation; et
- L'électrode de drain du transistor PMOS est connectée à une résistance de sortie dudit canal;

Dans lequel, dans tous les canaux :

- Les tensions de polarisation ont une même valeur de tension prédéfinie ;
- Les résistances de polarisation ont une même première valeur de résistance prédéfinie ; et,
- Les résistances de sortie ont une même seconde valeur de résistance prédéfinie ; et, dans lequel les résistances de sortie de tous les canaux sont connectées ensemble de telle sorte que les courants générés par les canaux à travers les électrodes de drain des transistors PMOS vont s'additionner à un courant total qui est indicatif de la valeur quantifiée.

4. Le préprocesseur analogique selon la revendication 3, dans lequel l'étage de sortie comprend :

- Un amplificateur en configuration d'inverseur qui, est conçu pour recevoir la tension d'entrée, est configuré pour générer un courant électrique qui indique la tension d'entrée et, est couplé aux résistances de sortie des canaux de telle sorte que ledit courant électrique qui indique la tension d'entrée est soustrait au courant total générant ainsi un courant électrique de sortie indiquant l'erreur de quantification ; and
- Un convertisseur courant-tension configuré pour recevoir le courant électrique de sortie et pour convertir ledit courant de sortie en la tension de sortie.

5. Le préprocesseur analogique selon l'une quelconque des revendications précédentes, dans lequel l'étage d'entrée est configurée pour générer une tension de commande inférieure à la tension d'entrée d'une quantité prédéfinie.

6. Un convertisseur analogique-numérique configuré pour convertir une tension d'entrée en un mot numérique qui comprend N bits indiquant une valeur quantifiée qui est obtenue par l'intermédiaire d'une quantification sur les $2^N$ niveaux de la tension d'entrée et est affecté par une erreur de quantification, où N est un nombre entier égal à, ou supérieur à un ; le convertisseur analogique-numérique comprenant le préprocesseur analogique défini selon l'une quelconque des revendications précédentes.

7. Le convertisseur analogique-numérique selon la revendication 6, comprenant un encodeur configuré pour :

- L'acquisition de tensions présentes sur les électrodes de drain des transistors PMOS des canaux du préprocesseur analogique; et
- La génération de N bits du mot numérique sur la base des tensions acquises.

8. Le convertisseur analogique numérique selon la revendication 6 ou 7, dans lequel le mot numérique comprend en outre M bits et dans lequel M est un nombre entier égal, ou supérieur à un ; le convertisseur analogique-numérique comprenant un convertisseur analogique-numérique de type flash, qui est couplé au préprocesseur analogique pour recevoir la tension de sortie générée par ledit préprocesseur analogique et est configuré pour convertir la tension reçue par le préprocesseur analogique en M bits du mot numérique.

FIG. 1

18

a)

b)

FIG. 2

EP 2 541 775 B1

FIG. 3

FIG. 4

## FIG. 5

N-MOS

100k

$V_p$  $i_{out}$

G  T1

D  S

G

S  D

P-MOS  10k

$V_{in}$

## FIG. 6

$V_p$

1.5k  R1

$V_n$

A1

$V_1$

$V_1$

3.38k  R2

$V_p$

10k  R3

10k  R4

$V_n$

A2

$V_o$  $V_{in}$

10k  R5  $V_s/2$

$V_p$

$V_s$

10k  R6

100k  R7  T1

$V_p$

10k  R8

$I_1$

FIG. 7

FIG. 8

FIG. 9

FIG. 10

EP 2 541 775 B1

FIG. 11

FIG. 12

FIG. 13

FIG. 14

**EP 2 541 775 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 9003066 A